(19) Europäisches Patentamt
European Patent Office
Office européen des brevets

(11) Publication number: 0 092 435 A1

# (12) EUROPEAN PATENT APPLICATION

(21) Application number: 83302235.3

(22) Date of filing: 20.04.83

(51) Int. Cl.³: C 30 B 25/12

(30) Priority: 20.04.82 JP 65814/82

(43) Date of publication of application: 26.10.83
Bulletin 83/43

(84) Designated Contracting States: DE FR GB NL

(71) Applicant: TOKYO SHIBAURA DENKI KABUSHIKI KAISHA, 72, Horikawa-cho Saiwai-ku, Kawasaki-shi Kanagawa-ken 210 (JP)

(72) Inventor: Kotani, Shigeo C/O Patent Division, Tokyo Shibaura Denki KK 72 Horikawa-cho Saiwai-ku, Kawasaki-shi Kanagawa-ken Tokyo (JP)
Inventor: Kubota, Hiroyasu C/O Patent Division, Tokyo Shibaura Denki KK 72 Horikawa-cho Saiwai-ku, Kawasaki-shi Kanagawa-ken Tokyo (JP)

(74) Representative: Batchellor, John Robert et al, BATCHELLOR, KIRK & EYLES 2 Pear Tree Court Farringdon Road, London EC1R 0DS (GB)

## (54) A method of, and a susceptor for use in, vapour deposition of films.

(57) A method is described for vapour deposition films, for example epitaxial films, in which a wafer (15) to receive a film is supported in a recess (12) on a susceptor (10). The recess (12) is in a body (11) portion of the susceptor (10) and has a step (13) on which the wafer (15) is supported at its edge. A bottom surface (14) of the recess (12) extends substantially parallel to the wafer (15) so that heating of the wafer (15) is uniform except for a small part adjacent the contact point with the step (13).

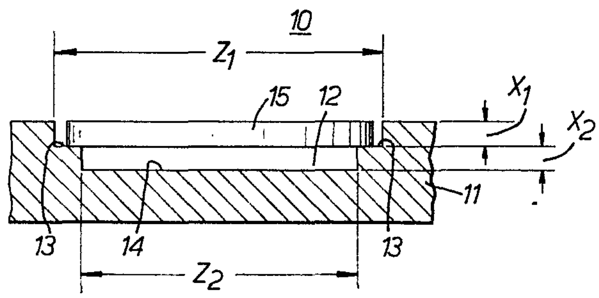


EP 0 092 435 A1

# A Method of, and a Susceptor for use in, Vapour Deposition of Films.

This invention relates to the field of vapour deposition of films on substrates, and in particular, though not exclusively to the vapour deposition of epitaxial films, for example silicon and like films, on exposed surfaces of materials, such as silicon wafer substrates commonly used in the electronics industry.

In known vapour deposition methods, gaseous chemical reactants are brought into contact with heated substrates in a reactor. Uniform heating of the substrates is required to obtain high quality films. The most common technique of heating is radio frequency (RF) induction heating of a conducting susceptor or wafer carrier positioned within the reaction chamber, which has walls of non-conducting or insulating materials. It is well known to use RF heating of a graphite susceptor coated with silicon carbide (SiC) within a quartz reaction chamber for depositing epitaxial silicon films.

It is very difficult to keep a susceptor at uniform temperature, throughout the process of raising and lowering the temperature. For example, during the temperature elevation, the high voltage side of the RF induction coil or the lower course of reactants stream may reach a specified temperature too quickly. Portions of the substrate wafer on the susceptor will be at different temperatures. Inequality of temperature causes crystal defects or slip and lack of uniform thickness. Such defects and lack of uniformity cause leakage current, low breakdown voltages, and poor yield of semiconductor devices. Referring to Figure 1, which illustrates a known method, substrate wafers 2 are placed on the flat surface of a susceptor 1. In this case, if portions of the susceptor are at different temperatures or the substrate wafer 2 is in non-uniform contact with the susceptor, the substrate may also not be at a uniform

temperature. U.S. Patent No. 3,594,227 shows rotating substrate holders having circular recesses which, it is stated, result in a very uniform thin film deposition. However, complicated mechanisms are required to rotate the susceptor assembly. On the other hand, Japanese patent publication 50-12971 shows a simple way of uniform heating. As shown in Figure 2, the susceptor body 3 has a concave surface 4 which gently slopes from the edge toward the centre. The substrate 5 is placed on the concaved surface 4. Heat conducts through the contact points of susceptor body 3 and substrate 5 and by radiation from the concave surface 4 to the back surface of substrate 5. Another prior art device is shown in Figure 3. In this device, the recess has a step 4'a to support the substrate 5' and heat is conducted through the contact surface of step 4'a and substrate 5' and radiated from the concave surface 4' to the back surface of substrate 5'. These prior art susceptors are simple and effective for a particular region of the substrate wafer. Nowadays larger substrate wafers are required to increase productivity and the prior art methods are then not sufficient.

Accordingly, one aspect of the invention provides a method of depositing a film on a generally planar semiconductor wafer comprising the steps of: supporting the semiconductor wafer in a recess on a susceptor, so that a major part of the wafer does not contact the susceptor, and is substantially parallel to and adjacent to a bottom surface of the recess; placing the susceptor with the wafer in a reactor; heating the wafer to a temperature suitable for epitaxial deposition; and introducing gaseous reactants into reactor, so that deposition can take place.

Accordingly, another aspect of the invention provides a susceptor for use in depositing a film on at least one semiconductor wafer supported on the susceptor, comprising: a body portion; at least one recess in an upper surface of the body portion, for receiving respectively the

at least one semiconductor wafer; a step in the recess for supporting the at least one wafer so that a major part of the wafer does not contact the body and is substantially parallel and adjacent to a bottom surface of the recess.

This invention thus provides a method and susceptor for producing epitaxial films whereby a uniform temperature may be established and maintained over the major part of the surface area of the substrate wafers while it is treated with gases.

A preferred embodiment of the invention will now be described by way of example and with reference to the accompanying drawings:

Figure 1 is a partly cutaway, perspective view of substrate wafers on a prior art susceptor;

Figure 2 is a sectional view of a prior art susceptor;

Figure 3 is a sectional view of another prior art susceptor;

Figure 4 is a sectional view of the preferred embodiment of this invention;

Figure 5 is a sectional view illustrating slip in the substrate wafer;

Figure 6 is a temperature profile across a wafer using the preferred embodiment;

Figure 7A is a view of half of the front surface of the processed wafer;

Figure 7B is a view of half of the back surface of the processed wafer;

Figure 8A is a graph of the distribution of total slip length of sample wafers produced by the preferred embodiment; and

Figure 8B is a graph of the distribution of total slip length of sample wafers produced by the Figure 3 prior art.

Referring to Figure 4 and subsequent figures, a susceptor 10 has a recess 12 at the surface of susceptor body 11. It is to be understood that body 11 typically has a plurality of such recesses 12 over its surface, and such recesses can be differing shapes but preferably are circular. The recess 12 has a step 13 which supports the edge of wafer 15, and a bottom surface 14 which is parallel to the top surface of step 13. The upper part of the recess 12, about the step 13, has a diameter $Z_1$ which is slightly larger than the diameter of wafer 15. The diameter $Z_2$ of the lower part of the recess 12 measured from the inner edge of step 13 is slightly smaller than the diameter of wafer 15. Therefore, wafer 15 can be placed on and supported by the step 13 within the recess 12. The body 11 is advantageously made of graphite coated with silicon carbide (SiC) by the Chemical Vapour Deposition (CVD) method to a thickness of about 10 μm. The SiC coating prevents impurities from evolving from the material when it is heated from 1000-1250°C during the epitaxial reaction. One reason that opening diameter $Z_1$ is slightly larger than the diameter of wafer 15 is to facilitate the positioning of wafer 15 in the recess 12 and to facilitate its subsequent removal. A second reason is to prevent strain on the wafer 15 caused by expansion due to heating during the reaction process. Unless the recess is sufficiently larger than the wafer, such strain can occur.

The size of the lower part of the recess 12, having diameter $Z_2$ defined by the inner edge of step 13, is chosen so that the edge of wafer 15 is supported, and so that preferably the upper edge portion of step 13 extends under wafer 15 for about 5% of the wafer's diameter. The depth $X_1$ from the top surface of the body 11 to the upper surface of supporting step 13 is chosen to equal the thickness of wafer 15. This construction allows smooth and even flow of the reactant gases, to ensure uniform contact with wafer 15

and prevent temperature loss from wafer 15.

The depth $X_2$ from the upper surface of supporting step 13 to the bottom or recess 14 depends primarily on the diameter of wafer 15 and to a less extent on the type of gaseous reactant.

When the depth $X_2$ is too large, the heat energy transmitted from susceptor 10 to wafer 15 is insufficient and it is impossible to raise the temperature of substrate wafer 15 uniformly or sufficiently. On the other hand, when the depth $X_2$ is too small, it is difficult to keep the temperature uniform over the surface of wafer 15 thereby resulting in stress or crystal defect. The temperature of the process should be selected corresponding to the reactant gas, shown in Table 1 for example.

Table 1

| Reactant Gas | Temperature |
|---|---|
| $SiCl_4$ | 1200°C |
| $SiHCl_3$ | 1150°C |
| $SiH_2Cl_2$ | 1100°C |
| $SiH_4$ | 1000°C |

In operation, after putting the substrate wafer 15 on the supporting step 13 of susceptor 10, susceptor 10 is positioned in a conventional reactor. RF energy is applied to a coil surrounding the reactor and the susceptor 10 is heated. This heat energy is transmitted from the supporting step 13 of the susceptor to the edge portion of wafer 15, and from the bottom 14 of recess 12 to the back surface of wafer 15. The temperature of the edge portion of wafer 15 rises rapidly, and heat conduction occurs through the full thickness of the wafer and from the edge to the centre. Gaseous reactant is then introduced into the reactor.

Using this embodiment of the present invention a

uniform rise of temperature occurs over the whole wafer 15. As shown by the sectional view of Figure 5, any slip is restricted to the edge region of the wafer. Furthermore, heat stress by the heat rise of wafer 15 is absorbed in the edge region so the appearance of slip is eliminated other than in the edge portion.

An example reaction arrangement will now be described wherein:

the dimensions of the susceptor recess are selected to be

$X_1$ = 650 $\mu m$ (nearly equal to the thickness of substrate wafer)

$X_2$ = 80 $\mu m$

$Z_1$ = 102 mm (diameter of wafer is 100 mm )

$Z_2$ = 90 mm

Gaseous reactants are

$SiC_4$ and $H_2$

Reaction formula is:

$$SiCl_4 + 2H_2 \rightleftarrows Si + 4HCl$$

(In actuality, the reaction is more complex. Depending upon reactant concentration, temperature, pressure and reactor geometry, various side reactions can also occur.)

The temperature distribution profile using an arrangement as suggested above is shown in Figure 6. That is, the susceptor is heated to 1230°C, the edge wafer 15 contacting the susceptor is at 1210°C and the area of wafer 15 not touching the susceptor surface is at 1180°C , after a steady state is reached.

Figure 7A shows half of the front top surface of wafer 15 after this epitaxial process. Slips are confined to the marginal area, in particular the area over that which was in contact with the susceptor 10.

Figure 7B shows half of the back surface of wafer 15. A thin film of poly-silicon occurs on the edge area which was in contact with the susceptor 10. It seems that

the high temperature of this area causes growth of the thin film from the gaseous reactant which diffused to the back side of the wafer 15. However, the thickness of the film on the back side is 0.1 μm at most in the case of reactant being $SiCl_4$ at temperature 1200°C, while the thickness of film on the front surface is 10 μm. This thin film does not affect the subsequent processings of the wafer, for example, warp or slip does not occur in oxidation or diffusion process and shears in masking or poor contact are not affected during the photo engraving process.

Table 2 shows the comparison with the prior art of the "ratio of slip free area", which is defined as follows:

1. Cover all slips in visual inspection by respective 2.5mmx2.5mm squares which is the typical size of a bi-polar IC.
2. Sum the area covered by square, as "a".
3. Size of all is "A".
4. "Ratio of slip free area" is
   $100 \times (A - a)/A$ (%)

Table 2

| Type of Susceptor | Ratio of Slip Free Area |
|---|---|
| This embodiment | 95 ~ 100% |
| Flat surface (Fig. 1) | 40 ~ 50% |
| Concaved surface (Fig. 3) | 40 ~ 70% |

This table shows an effectiveness of this invention. Sirtl etching inspection, which is a well known examination technique for crystal defect, supports the effectiveness of this invention. Under a Sirtl etching inspection, the prior art shows worse results than the

visual inspection shown in the above table, while the described embodiment keeps equal ratio to the visual inspection.

Figures 8A and 8B show another interesting comparison with the prior art. They show the distribution of total slip length, which is defined as the sum total of each slip length of one substrate wafer, by visual inspection. Figure 8A shows the results of visually inspecting 24 samples made by this embodiment. Figure 8B shows the results produced by the prior art illustrated in Figure 3 for which 32 samples were inspected. A distribution pattern of the embodiment of this invention has a peak at low slip length. On the other hand, the prior art (Figure 3) has a distribution pattern with a peak in the middle, and both peak and average values are higher than for a described embodiment.

In summary, what has been disclosed is a novel method and susceptor for vapour deposition in general and for an epitaxial reaction which produces epitaxial material of high quality and excellent uniformity. In particular surface imperfections in the epitaxial film such as slip are substantially eliminated.

CLAIMS:

1. A method of depositing a film on a generally planar semiconductor wafer (15) comprising the steps of: supporting the semiconductor wafer (15) in a recess (12) on a susceptor (11), so that a major part of the wafer (15) does not contact the susceptor (11), and is substantially parallel to and adjacent to a bottom surface (14) of the recess (12); placing the susceptor (11) with the wafer (15) in a reactor; heating the wafer (15) to a temperature suitable for epitaxial deposition; and introducing gaseous reactants into reactor, so that deposition can take place.

2. A method as claimed in claim 1 wherein the wafer (15) is supported adjacent its outer periphery so that substantially the whole of the wafer (15) does not contact the susceptor (11).

3. A method as claimed in claim 1 or 2 wherein the wafer (15) is in part heated by radiation transmitted from the bottom surface (14) substantially parallel to the wafer (15).

4. A method as claimed in claim 1, 2 or 3 wherein the wafer (15) is supported in a recess (14) slightly larger than the wafer (15) on a step (13) which defines a boundary of the bottom surface (14) substantially parallel to the wafer (15) so that an opening to that surface is slightly smaller than the wafer (15).

5. A method as claimed in any one of claims 1 to 4 wherein the wafer (15) is supported at a depth within the recess (12) substantially equal to the thickness of the wafer (15).

6. A method as claimed in any one of claims 1 to 5

where the bottom surface is planar.

7. A susceptor for use in depositing a film on at least one semiconductor wafer (15) supported on the susceptor (10), comprising: a body portion (11); at least one recess (12) in an upper surface of the body portion (11), for receiving respectively the at least one semiconductor wafer (15); a step (13) in the recess (12) for supporting the at least one wafer (15) so that a major part of the wafer (15) does not contact the body (11) and is substantially parallel and adjacent to a bottom surface (14) of the recess (12).

8. A susceptor as claimed in claim 7 wherein the step (13) forms a boundary to a lower part of the recess (12) which has the bottom surface 14 and an opening so that the lower part is slightly smaller than the wafer (15).

9. A susceptor as claimed in claim 7 or 8 wherein the step (13) is at a depth in the recess (12) substantially equal to the thickness of the wafer (15), so that an upper surface of the wafer (15) is substantially the same level as the upper surface of the body portion (11).

10. A susceptor as claimed in claim 7, 8 or 9 wherein the susceptor body (11) is made of graphite.

11. A susceptor as claimed in any one of claim 7 to 10 wherein the susceptor body portion (11) is coated with silicon carbide.

12. A susceptor as claimed in any one of claims 7 to 11 wherein the bottom surface (14) of the recess (12) is planar.

0092435

1/3

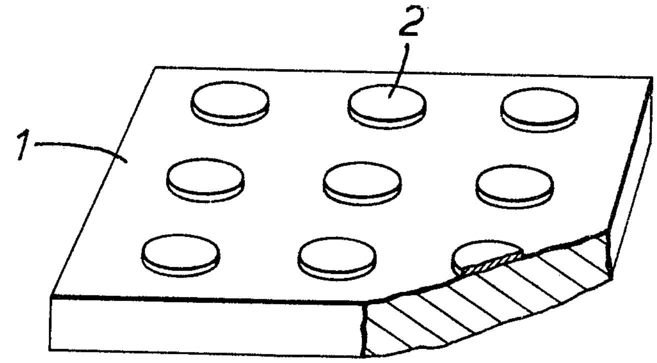


FIG. 1.
(PRIOR ART)

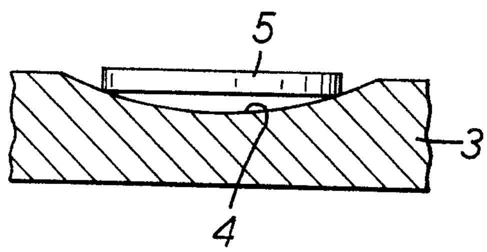


FIG. 2.
(PRIOR ART)

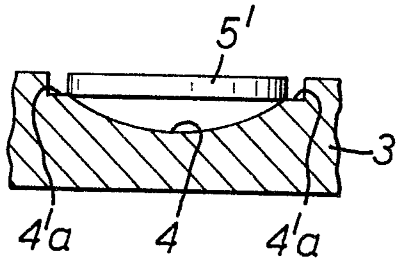


FIG. 3.
(PRIOR ART)

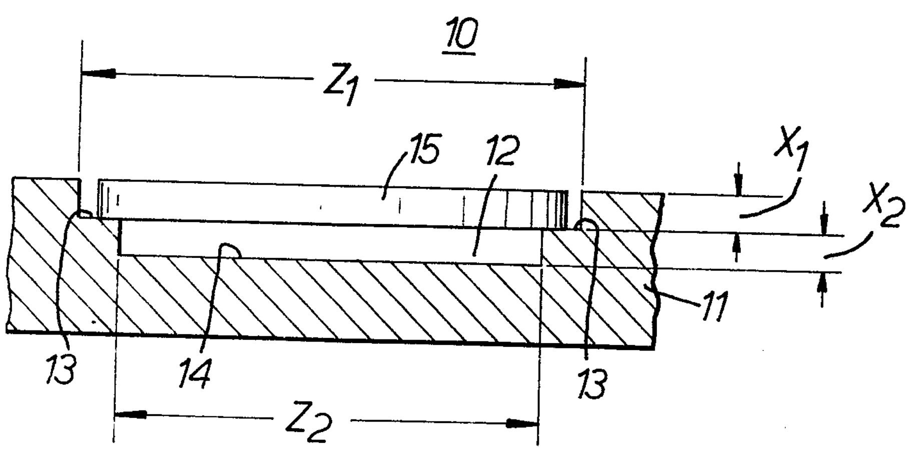


FIG. 4.

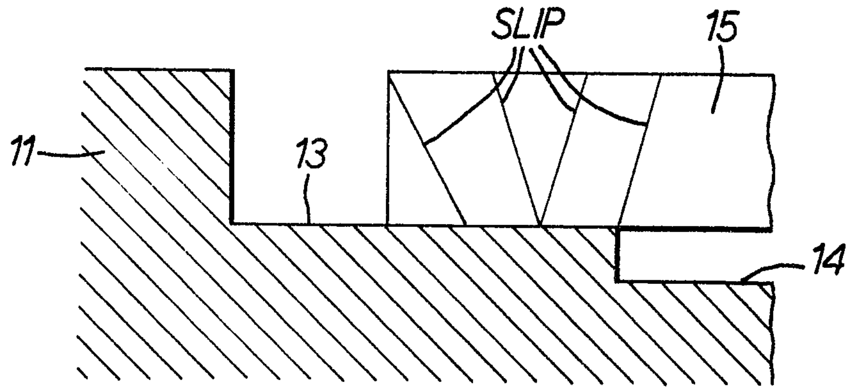


FIG. 5.

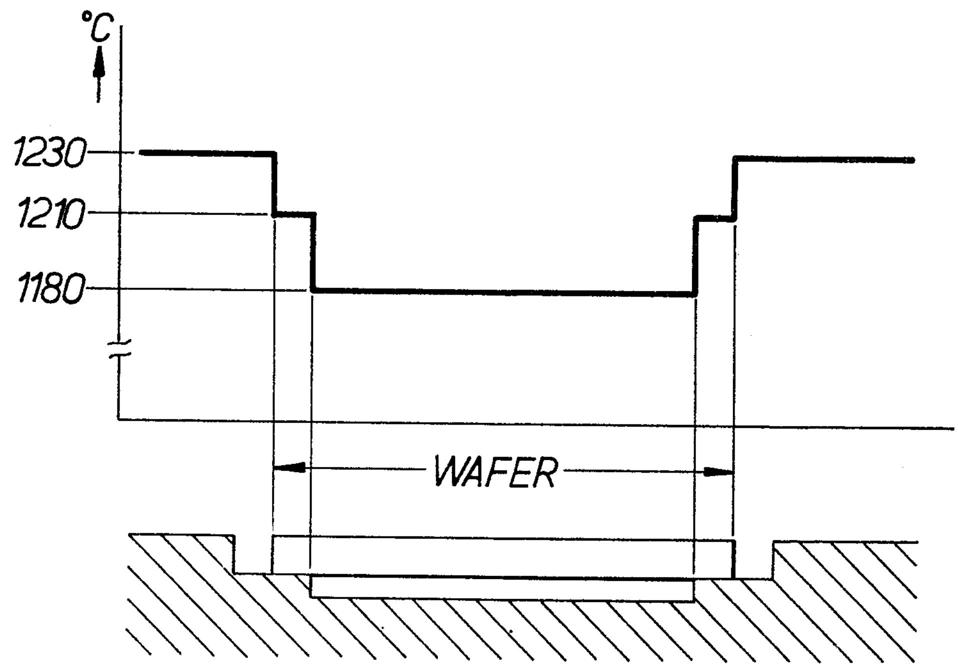


FIG. 6.

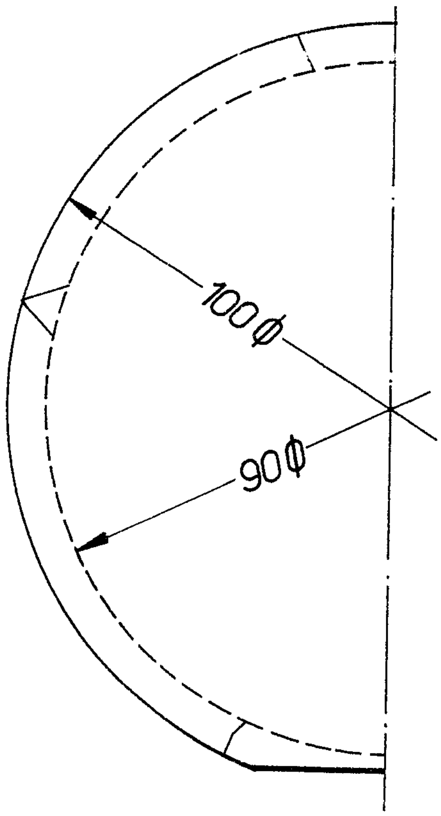


FIG. 7A.

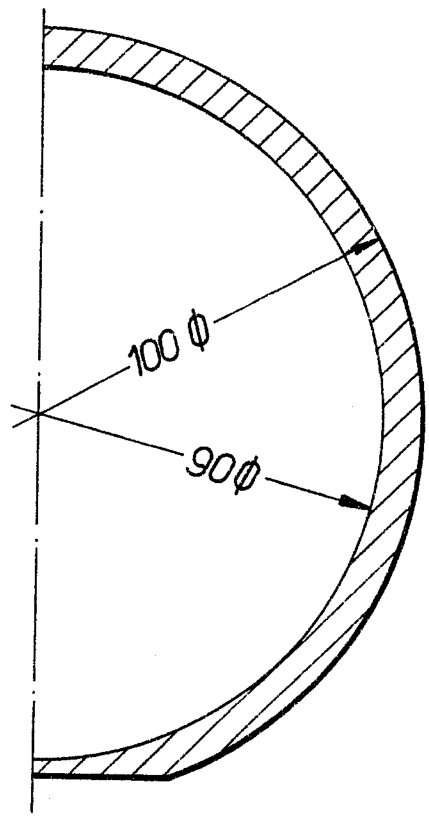


FIG. 7B.

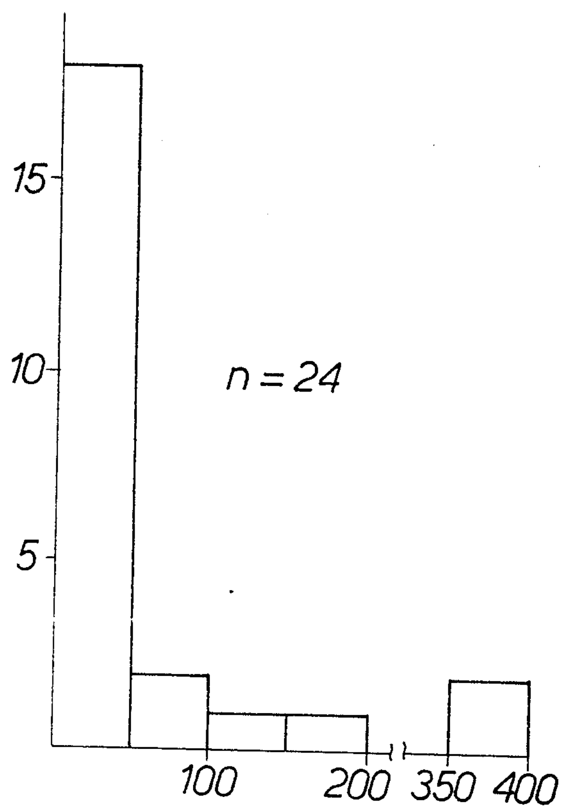


FIG. 8A.

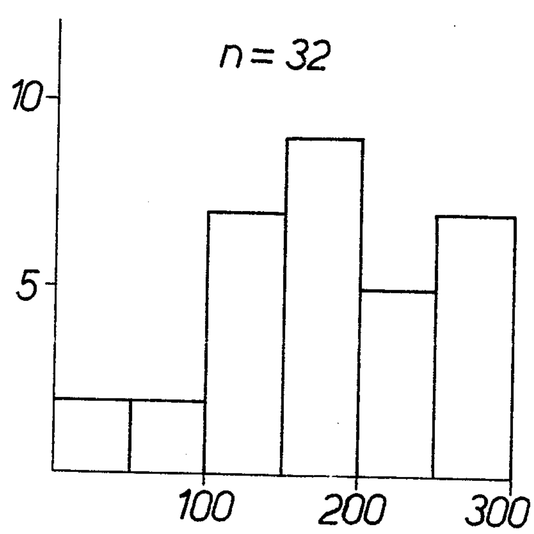


FIG. 8B.

0092435

European Patent Office

# EUROPEAN SEARCH REPORT

Application number

EP 83 30 2235

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | DE-A-1 956 055 (IBM)<br>* Claims; figure 3 *<br>--- | 1-4,6-8,10,12 | C 30 B 25/12 |
| X | GB-A-1 157 421 (MONSANTO)<br>* Claims; figures 6,10 *<br>----- | 1-10,12 | |
| | | | TECHNICAL FIELDS SEARCHED (Int. Cl. 3) |
| | | | C 30 B 25/12 |

The present search report has been drawn up for all claims

| Place of search | Date of completion of the search | Examiner |
|---|---|---|
| THE HAGUE | 19-07-1983 | BRACKE P.P.J.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82